# EUROPEAN PATENT APPLICATION

(11) **EP 3 540 901 A1**
(43) Date of publication of application: **18.09.2019**
(21) Application number: 19152697.9
(22) Date of filing: 21.01.2019
(51) Int. Cl.: H02J 7/00

(54) **METHOD AND SYSTEM FOR NOTIFYING A USER OF A CHARGING PROGRESS RELATED TO A RECHARGEABLE BATTERY THAT CORRESPONDS TO THE USER AND THAT IS BEING CHARGED AT A SERVICE END**

(30) Priority: 12.03.2018 TW 10708293
(71) Applicant: Kwang Yang Motor Co., Ltd., Kaohsiung City 80794 (TW)
(72) Inventor: HSIEH, Ping-Jui, Kaohsiung City 83093 (TW); HUNG, Chung-Jui, Kaohsiung 80794 (TW); CHEN, Yuh-Rey, Taipei City 11501 (TW); CHUANG, Po-Yu, Taipei City 11501 (TW); LIN, Jen-Chiun, Taipei City 11501 (TW); LIU, Te-Chuan, Taipei City 11501 (TW)
(74) Representative: Verriest, Philippe

(57) **Abstract**

A method for notifying a user of a charging progress related to a rechargeable battery (1) that corresponds to the user and that is being charged at a service end is proposed. The service end transmits a user identifier corresponding to the user and a battery identifier corresponding to the rechargeable battery (1) to a cloud server (2) . The service end periodically transmits the charging progress to an electronic device of the user via the cloud server (2) when the rechargeable battery (1) is being charged by a charger (5) of the service end.

## Description

The disclosure relates to charging of rechargeable batteries of electric vehicles, and more particularly to a method and a system for notifying a user of a charging progress related to a rechargeable battery that corresponds to the user and that is being charged at a service end.

When a rechargeable battery of an electric vehicle is running out of power, a user of the electric vehicle may charge the rechargeable battery at a charging station. However, the rechargeable battery usually takes a long time to charge because of its large capacity. Using existing charging techniques may cost about two hours to charge a rechargeable battery from 0 to 80% of its maximum capacity, and three to four hours to fully charge a rechargeable battery. If the user has other matters to attend to as the rechargeable battery is being charged, he/she cannot know the charging progress without making an inquiry with the service site, making it inconvenient.

Therefore, an object of the disclosure is to provide a method that enables the user to periodically receive the charging progress related the rechargeable battery which is being charged at the charging station (a service end), without any active inquiry on the part of the user.

According to the disclosure, a method for notifying a user of a charging progress related to a rechargeable battery that corresponds to the user and that is being charged at a service end is proposed to include: by a cloud server, receiving, from a service end electronic device of the service end, a user identifier that corresponds to a user end electronic device of the user and that is acquired by the service end electronic device, wherein the cloud server is communicatively coupled to the user end electronic device and the service end electronic device; by the cloud server, receiving, from the service end electronic device, a battery identifier that corresponds to the rechargeable battery and that is acquired by the service end electronic device; and by the cloud server, periodically transmitting, after the rechargeable battery is connected to a charger of the service end and the charger starts charging the rechargeable battery, a charging progress of the rechargeable battery to the user end electronic device based on the user identifier upon receipt of the charging progress from the service end. The charger is communicatively coupled to the cloud server, and the charging progress relates to electric energy currently stored in the rechargeable battery.

Another object of the disclosure is to provide a system that enables the user to periodically receive the charging progress related the rechargeable battery which is being charged at the charging station (a service end) without any active inquiry on the part of the user.

According to the disclosure, a system for notifying a user of a charging progress related to a rechargeable battery that corresponds to the user and that is being charged at a service end is proposed to include a user end electronic device of the user, a service end electronic device of the service end, a charger of the service end, and a cloud server. The user end electronic device corresponds to a user identifier. The service end electronic device is configured to acquire the user identifier, and a battery identifier corresponding to the rechargeable battery. The charger is configured to charge the rechargeable battery. The cloud server is communicatively coupled to the user end electronic device, the server end electronic device and the charger, and is configured to: i) receive the user identifier and the battery identifier from the service end electronic device, and ii)periodically transmit, after the rechargeable battery is connected to the charger and the charger starts charging the rechargeable battery, a charging progress of the rechargeable battery to the user end electronic device based on the user identifier upon receipt of the charging progress from the service end. The charger is communicatively coupled to the cloud server, and the charging progress relates to electric energy currently stored in the rechargeable battery.

Other features and advantages of the disclosure will become apparent in the following detailed description of the embodiment (s) with reference to the accompanying drawings, of which:
FIG. 1 is a block diagram illustrating an embodiment of the system for notifying a user of a charging progress related to a rechargeable battery that corresponds to the user and that is being charged at a service end according to the disclosure;
FIG. 2 is a flow chart illustrating steps of an embodiment of the method for notifying a user of a charging progress related to a rechargeable battery that corresponds to the user and that is being charged at a service end according to the disclosure;
FIG. 3 is a flow chart illustrating details of transmitting the charging progress to a user end electronic device; and
FIG. 4 is a flow chart illustrating details of issuing a completion notification to the user end electronic device after completion of charging.

Before the disclosure is described in greater detail, it should be noted that where considered appropriate, reference numerals or terminal portions of reference numerals have been repeated among the figures to indicate corresponding or analogous elements, which may optionally have similar characteristics.

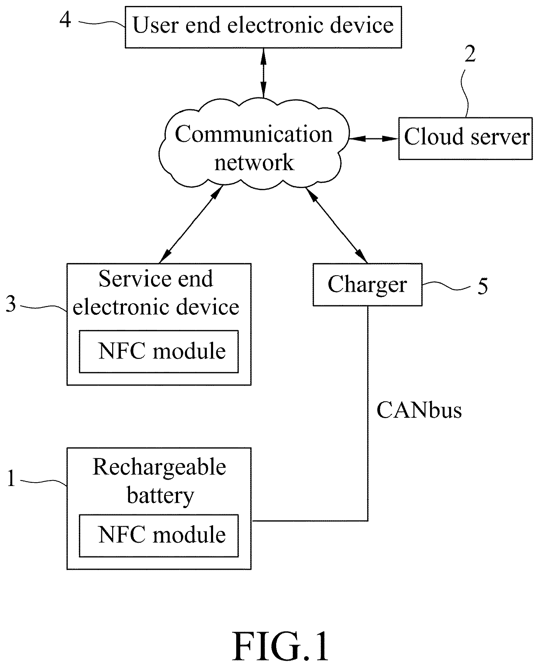

Referring to FIG. 1, the embodiment of the system for notifying a user of a charging progress related to a rechargeable battery 1 that corresponds to the user and that is being charged at a service end (e.g., a charging station) according to this disclosure is shown to include a cloud server 2, a service end electronic device 3 of the service end, a user end electronic device 4 of the user, and a charger 5 of the service end.

The cloud server 2 may be realized by a personal computer or a cloud host computer, and store a plurality of battery identifiers and a plurality of user identifiers. The battery identifiers respectively correspond to multiple rechargeable batteries for use in electric vehicles, and each of the battery identifiers corresponds to one of the user identifiers. Each user identifier corresponds to a user end electronic device, and a contract identifier which corresponds to one of a long-term rental contract and a short-term rental contract.

In practice, the manufacturer of the electric vehicle may print, for each rechargeable battery for use by electric vehicles, the battery identifier on a sticker in a form of a two-dimensional barcode, such as a quick response code (QR code), and attach the sticker to a side of the rechargeable battery. In another implementation, the battery identifier may be stored in an internal storage module (not shown) of the corresponding rechargeable battery.

Because the rechargeable batteries for use by electric vehicles are expensive, it is common practice for the user to make a battery rental contract with the dealer when purchasing an electric vehicle . The battery rental contract may be the long-term rental contract or the short-term rental contract, as desired by the user. As an example, when the user chooses to make the long-term rental contract, the user may charge the rechargeable battery at the charging station of the dealer; and, when the user chooses to make the short-term rental contract, the user is not allowed to charge the rechargeable battery at the charging station of the dealer. After purchasing the electric vehicle, the user may install an application program (user end application program) on his/her mobile phone or tablet computer (i.e., the user end electronic device 4) to register user information and battery rental contract information, so that the application program generates the user identifier in a form of a 2D barcode (e.g., a QR code), where the user identifier corresponds to the contract identifier that indicates a type of the battery rental contract (e.g., the long-term rental contract or the short-term rental contract). The user end electronic device 4 is communicatively coupled to the cloud server 2 via a communication network (e.g., the Internet), so that the registration data can be transmitted to the cloud server 2, so as to tie a vehicle identifier (which corresponds to the purchased electric vehicle and which may be provided to the cloud server 2 by the dealer), the battery identifier, the user identifier and the contract identifier together in the cloud server 2. In other words, a correspondence relationship among the vehicle identifier, the battery identifier, the user identifier and the contract identifier is defined and stored in the cloud server 2. In one implementation, the user identifier may be stored in an internal storage unit of the user end electronic device 4 after being generated by the application program.

The service end electronic device 3 may be a mobile device, such as a mobile phone or a tablet computer. In a case that the user identifier is stored in the corresponding user end electronic device 4 and the battery identifier is stored in the rechargeable battery 1, the service end electronic device 3 may use short range communication, such as the near field communication (NFC) protocol, to acquire the user identifier and the battery identifier from the user end electronic device 4 and the rechargeable battery 1, respectively. In a case that the user identifier is shown on the user end electronic device 4 as a QR code via the application program and the battery identifier is printed as a QR code on the sticker attached to the rechargeable battery 1, the service end electronic device 3 may scan the QR codes to acquire the user identifier and the battery identifier from the user end electronic device 4 and the rechargeable battery 1, respectively. The service end electronic device 3 is communicatively coupled to the cloud server 2 via the communication network, so the service end electronic device 3 can transmit the acquired user identifier and battery identifier to the cloud server 2.

The charger 5 is configured to charge the rechargeable battery 1, and is capable of communication with the rechargeable battery 1 via a controller area network bus (CANbus) for reading battery information related to the rechargeable battery 1. The charger 5 is communicatively coupled to the cloud server 2 via the communication network, so the charger 5 can transmit data acquired thereby to the cloud server 2.

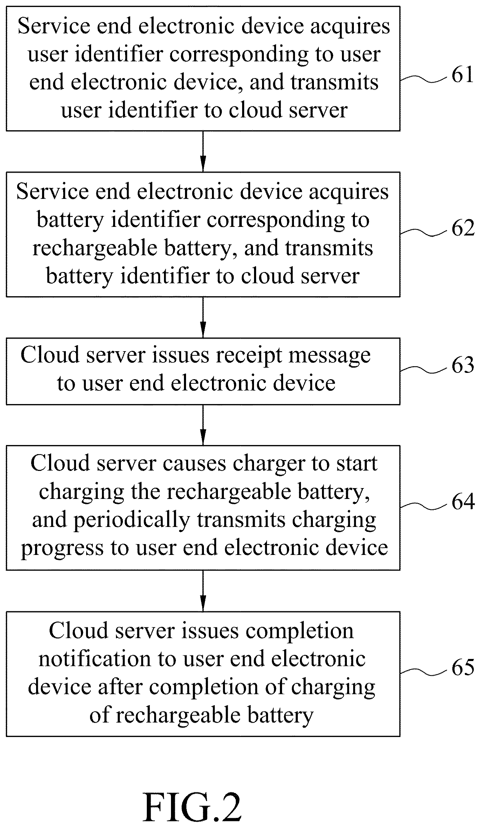

Further referring to FIG. 2, when the user takes the rechargeable battery 1 to the service end (e.g., the charging station of the dealer) for battery charging, the service end may perform the following steps 61-65 to implement the method for notifying the user of a charging progress of the rechargeable battery 1 according to this disclosure.

In step 61, the service end electronic device 3 acquires the user identifier corresponding to the user end electronic device 4 of the user, and transmits the user identifier to the cloud server 2. The service end electronic device 3 may execute a service end application program to scan the QR code that corresponds to the user identifier (user end QR code) and that is obtained by the user end electronic device 4 executing the user end application program to acquire the user identifier, or use the NFC protocol to acquire the user identifier stored in the user end electronic device 4.

In step 62, the service end electronic device 3 acquires the battery identifier that corresponds to the rechargeable battery 1, and transmits the battery identifier to the cloud server 2. The service end electronic device 3 may execute a service end application program to scan the QR code that corresponds to the battery identifier (battery QR code) and that is shown on a side (e.g., a top side) of the rechargeable battery 1 to acquire the battery identifier, or use the NFC protocol to acquire the battery identifier stored in the rechargeable battery 1. The service end electronic device 3 may also use the NFC protocol to acquire battery information that is stored in the rechargeable battery 1, and transmit the battery information along with the battery identifier to the cloud server 2. The battery information includes battery health information (e.g., state of health (SoH) of the rechargeable battery) and battery fault information that relate to the rechargeable battery 1. The battery health information is associated with a current maximum capacity of the rechargeable battery 1, and the battery fault information is associated with a damage condition of the rechargeable battery 1.

The cloud server 2 determines whether the user identifier to which the received battery identifier corresponds (as defined in one of predefined correspondence relationships stored in the cloud server 2) is identical to the user identifier received in step 61. When the determination is affirmative, meaning that the correspondence between the user identifier received in step 61 and the battery identifier received in step 62 has been confirmed, the cloud server 2 checks whether the contract identifier corresponding to the battery identifier corresponds to the long-term rental contract, and the flow goes to step 63 only when the determination is affirmative.

In step 63, the cloud server 2 issues a receipt message to the user end electronic device 4 based on the user identifier. The receipt message may include a QR code corresponding to the rechargeable battery 1 to be used by the user when retrieving the rechargeable battery 1 from the service end. In one implementation, along with transmitting the receipt message to the user end electronic device 4, the cloud server 2 further transmits the battery information received from the service end electronic device 3 to the user end electronic device 4, making the user aware of the maximum capacity and damage condition of the rechargeable battery 1.

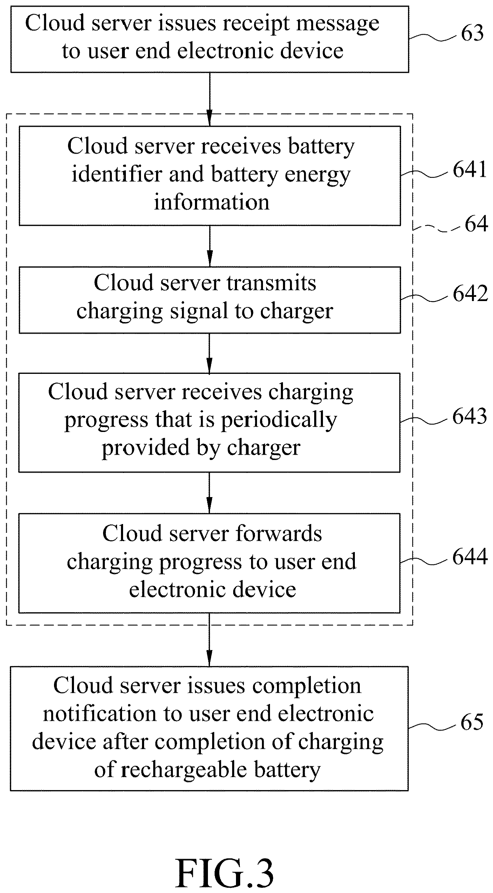

In step 64, the cloud server 2 causes the charger 5 to start charging the rechargeable battery 1 after the rechargeable battery 1 is connected to the charger 5, periodically receives a charging progress of the rechargeable battery 1 from the service end, and periodically transmits the charging progress to the user end electronic device 4. In detail, when the rechargeable battery 1 is connected to the charger 5, the charger 5 detects and transmits the battery identifier and battery energy information of the rechargeable battery 1 to the cloud server 2. The battery energy information indicates electric energy that is currently stored in the rechargeable battery 1. Further referring to FIG. 3, upon receipt of the battery identifier and the battery energy information that are detected by the charger 5 (sub-step 641), the cloud server 2 transmits a charging signal to the charger 5, so as to cause the charger 5 to start charging the rechargeable battery 1 based on the charging signal (sub-step 642). In one implementation, besides transmitting the charging signal to the charger 5, the cloud server 2 further issues a charging notification to the user end electronic device 4 based on the user identifier for notifying that charging for the rechargeable battery 1 has been started. When charging the rechargeable battery 1, the charger 5 detects the charging progress of the rechargeable battery 1 (the charging progress is associated with electric energy currently stored in the rechargeable battery 1), and periodically transmits the charging progress to the cloud server 2. Upon receipt of the charging progress that is periodically provided by the charger 5 (sub-step 643), the cloud server 2 forwards the charging progress to the user end electronic device 4 that corresponds to the user identifier (sub-step 644) . In one implementation, the cloud server 2 also forwards the charging progress to the service end electronic device 3.

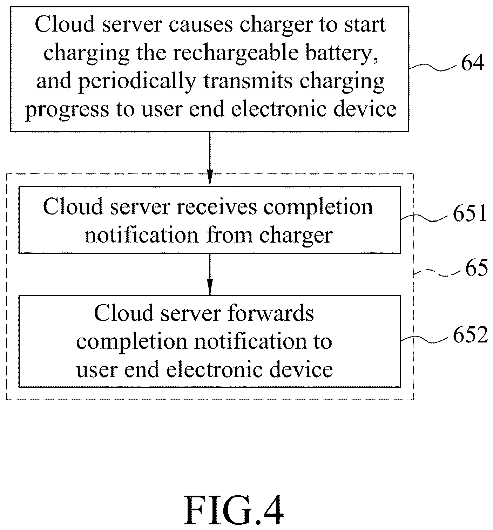

Referring to FIGS. 2 and 4, in step 65, the cloud server 2 issues, after completion of charging of the rechargeable battery 1, a completion notification to the user end electronic device 4 based on the user identifier for notifying that charging for the rechargeable battery 1 has been completed. In detail, the charger 5 issues the completion notification to the cloud server 2 after completion of charging of the rechargeable battery 1. Upon receipt of the completion notification from the charger 5 (sub-step 651), the cloud server 2 forwards the completion notification which is generated by and received from the charger 5 to the user end electronic device 4 based on the user identifier (sub-step 652). In one implementation, the cloud server 2 also forwards the completion notification to the service end electronic device 3. After reading the completion notification via the user end electronic device 4, the user becomes aware of completion of the charging, and may retrieve the rechargeable battery 1 from the service end using the receipt message received in step 63.

In a case that the user appoints a deputy to assist in bringing the rechargeable battery 1 to the service end for charging, the user may transmit the user end QR code that corresponds to the user identifier and that is generated by the user end application program to the deputy, so that steps 61-65 can be performed.

In summary, since the service end automatically and periodically reports the charging progress to the user end electronic device 4 via the cloud server 2, the user does not need to inquire into the charging progress with the service end and can still be aware of the charging progress.

In the description above, for the purposes of explanation, numerous specific details have been set forth in order to provide a thorough understanding of the embodiment (s) . It will be apparent, however, to one skilled in the art, that one or more other embodiments may be practiced without some of these specific details. It should also be appreciated that reference throughout this specification to "one embodiment," "an embodiment," an embodiment with an indication of an ordinal number and so forth means that a particular feature, structure, or characteristic may be included in the practice of the disclosure. It should be further appreciated that in the description, various features are sometimes grouped together in a single embodiment, figure, or description thereof for the purpose of streamlining the disclosure and aiding in the understanding of various inventive aspects, and that one or more features or specific details from one embodiment may be practiced together with one or more features or specific details from another embodiment, where appropriate, in the practice of the disclosure.

## Claims

1. A method for notifying a user of a charging progress related to a rechargeable battery (1) that corresponds to the user and that is being charged at a service end, **characterized by**:
by a cloud server (2), receiving, from a service end electronic device (3) of the service end, a user identifier that corresponds to a user end electronic device (4) of the user and that is acquired by the service end electronic device (3), wherein the cloud server (2) is communicatively coupled to the user end electronic device (4) and the service end electronic device (3);
by the cloud server (2), receiving, from the service end electronic device (3), a battery identifier that corresponds to the rechargeable battery (1) and that is acquired by the service end electronic device (3); and
by the cloud server (2), periodically transmitting, after the rechargeable battery (1) is connected to a charger (5) of the service end and the charger (5) starts charging the rechargeable battery (1), a charging progress of the rechargeable battery (1) to the user end electronic device (4) based on the user identifier upon receipt of the charging progress from the service end, wherein the charger (5) is communicatively coupled to the cloud server (2), and the charging progress relates to electric energy currently stored in the rechargeable battery (1).

2. The method of claim 1, further **characterized by**, after the cloud server (2) receives the battery identifier from the service end electronic device (3) : by the cloud server (2), issuing a receipt message to the user end electronic device (4) based on the user identifier, wherein the receipt message includes a quick response code corresponding to the rechargeable battery (1) to be used by the user in retrieving the rechargeable battery (1) from the service end.

3. The method of Claim 2, further **characterized by**:
by the cloud server (2), receiving battery information from the service end electronic device (3) along with the battery identifier, wherein the battery information is acquired by the service end electronic device (3) and includes battery health information and battery fault information that relate to the rechargeable battery (1), the battery health information being associated with a maximum capacity of the rechargeable battery (1), the battery fault information being associated with a damage condition of the rechargeable battery (1).

4. The method of Claim 3, further **characterized by**:
by the cloud server (2), transmitting the battery information to the user end electronic device (4) along with the receipt message.

5. The method of Claim 4, further **characterized by**:
receiving, from the charger (5), the battery identifier that is detected by the charger (5) and battery energy information that indicates electric energy currently stored in the rechargeable battery (1) and that is detected by the charger (5) when the rechargeable battery (1) is connected to the charger (5), and then transmitting a charging signal to the charger (5), so as to cause the charger (5) to start charging the rechargeable battery (1) based on the charging signal;
wherein the transmitting the charging progress includes:
periodically receiving the charging progress from the charger (5) when the rechargeable battery (1) is being charged by the charger (5); and
periodically forwarding the charging progress received from the charger (5) to the user end electronic device (4) that corresponds to the user identifier.

6. The method of Claim 5, further **characterized by**:
by the cloud server (2), issuing, as the charging signal is transmitted, a charging notification to the user end electronic device (4) based on the user identifier for notifying that charging for the rechargeable battery (1) has been started.

7. The method of Claim 1, further **characterized by**: by the cloud server (2), issuing, after completion of charging of the rechargeable battery (1), a completion notification to the user end electronic device (4) based on the user identifier for notifying that charging for the rechargeable battery (1) has been completed.

8. The method of Claim 7, **characterized in that** the issuing a completion notification includes: receiving, from the charger (5), the completion notification which is generated by the charger (5) after completion of charging of the rechargeable battery (1); and forwarding the completion notification which is generated by and received from the charger (5) to the user end electronic device (4) based on the user identifier.

9. The method of Claim 1, **characterized in that** the service end electronic device (3) acquires the user identifier by executing a service end application program to obtain the user identifier based on a user end quick response code (QR code), the user end QR code corresponding to the user identifier and being obtained by the user end electronic device (4) that executes a user end application program.

10. The method of Claim 1, **characterized in that** the service end electronic device (3) acquires the battery identifier based on a battery quick response code that is shown on a top side of the rechargeable battery (1) and that corresponds to the battery identifier.

11. The method of Claim 1, **characterized in that** the battery identifier is stored in the rechargeable battery (1), and the service end electronic device (3) acquires the battery identifier from the rechargeable battery (1) via a near field communication protocol.

12. A system for notifying a user of a charging progress related to a rechargeable battery (1) that corresponds to the user and that is being charged at a service end, **characterized by**:
a user end electronic device (4) of the user, said user end electronic device (4) corresponding to a user identifier;
a service end electronic device (3) of the service end, said service end electronic device (3) being configured to acquire the user identifier, and a battery identifier corresponding to the rechargeable battery (1);
a charger (5) of the service end, said charger (5) being configured to charge the rechargeable battery (1) ; and
a cloud server (2) communicatively coupled to said user end electronic device (4), said server end electronic device and said charger (5), and configured to:
receive the user identifier and the battery identifier from said service end electronic device (3), and periodically transmit, after the rechargeable battery (1) is connected to said charger (5) and said charger (5) starts charging the rechargeable battery (1), a charging progress of the rechargeable battery (1) to said user end electronic device (4) based on the user identifier upon receipt of the charging progress from the service end, wherein said charger (5) is communicatively coupled to said cloud server (2), and the charging progress relates to electric energy currently stored in the rechargeable battery (1).

13. The system of Claim 12, **characterized in that**, after said cloud server (2) receives the battery identifier from said service end electronic device (3), said cloud server (2) issues a receipt message to said user end electronic device (4) based on the user identifier, wherein the receipt message includes a quick response code corresponding to the rechargeable battery (1) to be used by the user in retrieving the rechargeable battery (1) from the service end.

14. The system of Claim 13, **characterized in that** said service end electronic device (3) is further configured to acquire battery information along with the battery identifier, and to transmit the battery information to said cloud server (2), wherein the battery information includes battery health information and battery fault information that relate to the rechargeable battery (1), the battery health information being associated with a maximum capacity of the rechargeable battery (1), the battery fault information being associated with a damage condition of the rechargeable battery (1).

15. The system of Claim 14, **characterized in that** said cloud server (2) is further configured to transmit the battery information to said user end electronic device (4) along with the receipt message.

16. The system of Claim 15, **characterized in that** said charger (5) is configured to, when the rechargeable battery (1) is connected to said charger (5), detect the battery identifier of the rechargeable battery (1) and battery energy information that indicates electric energy currently stored in the rechargeable battery (1), and to transmit the battery identifier and battery energy information to said cloud server (2);
wherein said cloud server (2) is further configured to transmit a charging signal to said charger (5) upon receipt of the battery identifier and the battery energy information from said charger (5), so as to cause said charger (5) to start charging the rechargeable battery (1) based on the charging signal; and
wherein said charger (5) periodically transmits the charging progress to said cloud server (2) when said charger (5) is charging the rechargeable battery (1), and said cloud server (2) periodically forwards the charging progress received from said charger (5) to said user end electronic device (4) that corresponds to the user identifier.

17. The system of Claim 16, **characterized in that** said cloud server (2) is further configured to issue, when transmitting the charging signal, a charging notification to said user end electronic device (4) based on the user identifier for notifying that charging for the rechargeable battery (1) has been started.

18. The system of Claim 12, **characterized in that** said cloud server (2) is further configured to issue, after completion of charging of the rechargeable battery (1), a completion notification to said user end electronic device (4) based on the user identifier for notifying that charging of the rechargeable battery (1) has been completed.

19. The system of Claim 18, **characterized in that** said charger (5) is further configured to issue the completion notification to said cloud server (2) after completion of charging of the rechargeable battery (1), and said cloud server (2) is further configured to forward the completion notification which is generated by and received from said charger (5) to said user end electronic device (4) based on the user identifier.

20. The system of Claim 12, **characterized in that** said service end electronic device (3) is configured to acquire the user identifier by executing a service end application program to obtain the user identifier based on a user end quick response code (QR code), the user end QR code corresponding to the user identifier and being obtained by said user end electronic device (4) that executes a user end application program.

21. The system of Claim 12, **characterized in that** said service end electronic device (3) is configured to acquire the battery identifier based on a battery quick response code that is shown on a top side of the rechargeable battery (1) and that corresponds to the battery identifier.

22. The system of Claim 12, **characterized in that** the battery identifier is stored in the rechargeable battery (1), and said service end electronic device (3) acquires the battery identifier from the rechargeable battery (1) via a near field communication protocol.
